# EUROPEAN PATENT SPECIFICATION

(11) **EP 2 082 286 B1**
(45) Date of publication and mention of the grant of the patent: **25.12.2013**
(21) Application number: 07863867.3
(22) Date of filing: 05.11.2007
(51) Int. Cl.: B29C 59/02, B82Y 40/00, B41C 1/00, G03F 7/00

(54) **SOLVENT-ASSISTED EMBOSSING OF FLEXOGRAPHIC PRINTING PLATES**
PRÄGUNG VON FLEXODRUCKPLATTEN MITHILFE VON LÖSUNGSMITTELN
GAUFRAGE DE PLAQUES D'IMPRESSION FLEXOGRAPHIQUE PAR SOLVANT

(30) Priority: 15.11.2006 US 865979 P
(43) Date of publication of application: 29.07.2009
(73) Proprietor: 3M Innovative Properties Company, St. Paul, MN 55133-3427 (US)
(72) Inventor: PEKUROVSKY, Mikhail L., Saint Paul, Minnesota 55133-3427 (US); WOLDT, Ryan T., Saint Paul, Minnesota 55133-3427 (US)
(74) Representative: Vossius & Partner
(86) International application number: PCT/US2007/083569
(87) International publication number: WO 2008/060876

(56) References cited:
- EP-A- 1 657 070
- EP-A- 1 700 680
- WO-A-00/30854
- US-A1- 2005 238 967
- LEE H H ET AL: "Fabrication of large-area stamps, moulds, and conformable photomasks for soft lithography" Proceedings of the Institution of Mechanical Engineers, Part N (Journal of Nanoengineering and Nanosystems) Mech. Eng. Publications UK, vol. 218, no. N1, 2005, pages 1-5, XP002478979 ISSN: 1740-3499
- KIM E ET AL: "SOLVENT-ASSISTED MICROCONTACT MOLDING: A CONVENIENT METHOD FOR FABRICATING THREE-DIMENSIONAL STRUCTURES ON SURFACES OF POLYMERS" ADVANCED MATERIALS, WILEY VCH, WEINHEIM, DE, vol. 9, no. 8, 1 June 1997 (1997-06-01), pages 651-654, XP000656812 ISSN: 0935-9648
- BRUNO M.: "Printing Meets Lithography" THE INDUSTRIAL PHYSICIST, 2002, XP009099601
- XIA Y ET AL: "SOFT LITHOGRAPHY" ANNUAL REVIEW OF MATERIALS SCIENCE, ANNUAL REVIEWS INC., PALO ALTO, CA, US, vol. 28, 1 January 1998 (1998-01-01), pages 153-184, XP009023786 ISSN: 0084-6600
- ZHAO ET AL.: "Rapid fabrication of a poly(dimethylsiloxane) microfluidic capillary gel electrophoresis system utilizing high precision machining" LAB CHIP, vol. 3, 2003, pages 93-99, XP002495541
- ELSNER C ET AL: "3D-microstructure replication processes using UV-curable acrylates" MICROELECTRONIC ENGINEERING, ELSEVIER PUBLISHERS BV., AMSTERDAM, NL, vol. 65, no. 1-2, 1 January 2003 (2003-01-01), pages 163-170, XP004392360 ISSN: 0167-9317
- LINDVOLD ET AL.: "UV assisted rotational moulding of microstructures using a conventional flexographic printing machine" SPIE, vol. 4984, 2003, pages 46-53, XP002495542
- GALE M T: "Replication techniques for diffractive optical elements" MICROELECTRONIC ENGINEERING, ELSEVIER PUBLISHERS BV., AMSTERDAM, NL, vol. 34, no. 3-4, 1 December 1997 (1997-12-01), pages 321-339, XP004108296 ISSN: 0167-9317
- DAVIES ET AL.: "Application of precision diamond machining to the manufacture of micro-photonics components" SPIE, vol. 5183, 2003, pages 94-108, XP002495543

## Description

### FIELD

This disclosure relates to flexographic printing plates; and more specifically to solvent-assisted embossing of flexographic printing plates.

### BACKGROUND

Flexographic printing plates are well known for use in relief printing on a variety of substrates such as paper, corrugated board, films, foils and laminates. Flexographic printing plates can be prepared from photo-sensitive elements having a photopolymerizable layer containing an elastomeric binder, a monomer, and a photo-initiator, interposed between a support and a cover sheet or multilayer cover element. One process of making such photo-sensitive elements is described in U.S. Pat. No. 4,460,675 where a previously extruded photo-polymerizable composition is fed into the nip of a calender and is calendered between a support and a multi-layer cover clement to form a photopolymerizable layer. Upon image-wise exposure of the photo-sensitive element with actinic radiation through a photomask, the exposed areas of the photo-polymerizable layer are insolubilized by photo-polymerization. Treatment with a suitable solvent or solvent mixture removes the unexposed areas of the photo-polymerizable layer leaving a printing relief which can be used for flexographic printing. Such materials and processes are described in U.S. Pat. No. 4,323,637; U.S. Pat. No. 4,427,759; and U.S. Pat. No. 4,894,315.
The article "Solvent-Assisted Microcontact Molding: A Convenient Method for Fabricating Three-Dimensional Structures on Surfaces of Polymers" by E. Kim et al., published in Advanced materials, Wiley VCH, Vol. 9, no. 8, pages 651-654, suggests using poly(dimethylsiloxane) (PDMS) mold.
The article "Soft Lithography" by Younan Xia et al., published in Annual Review of Materials Science, Vol. 28, pages 153-184, also relates to a soft lithography method.

However, developing the exposed photosensitive element with a solvent or solvent mixture is time consuming since drying for an extended period (0.5 to 24 hours) is necessary to remove entrained developer solution. In addition, these developing systems produce potentially toxic by-product wastes (both the solvent and any material carried off by the solvent) during the development process.

To avoid the problems with solution development, a "dry" thermal development process may be used. In a thermal development process, the photo-sensitive layer, which has been image-wise exposed to actinic radiation, is contacted with an absorbent material at a temperature sufficient to cause the composition in the unexposed portions of the photosensitive layer to soften or melt and flow into an absorbent material. See U.S. Pat. No. 3,264,103 (Cohen et al.); U.S. Pat. No. 5,015,556 (Martens); U.S. Pat. No. 5,175,072 (Martens); U.S. Pat. No. 5,215,859 (Martens); and U.S. Pat. No. 5,279,697 (Peterson et al.). In all these cited patents, image-wise exposure is conducted with a silver halide film target in a vacuum frame. The exposed portions of the photosensitive layer remain hard, that is, do not soften or melt, at the softening temperature for the unexposed portions. The absorbent material collects the softened un-irradiated material and then is separated and/or removed from the photosensitive layer. The cycle of heating and contacting the photosensitive layer may need to be repeated several times in order to sufficiently remove the flowable composition from the un-irradiated areas and form a relief structure suitable for printing. Thus remains a raised relief structure of irradiated, hardened composition that represents the desired printing image.

These methods are not able to form flexographic printing plates with feature sizes of less than 20 micrometers.

### BRIEF SUMMARY

The invention is defined by the features of the claims.

In a first embodiment, a method of forming a flexographic printing plate is described and includes disposing a polymeric substrate onto a master tool having a plurality of recesses defining a master tool pattern. The polymeric substrate comprises at least one elastomeric binder, at least one photopolymerizable, ethylenically unsaturated monomer or oligomer, and at least one photo-initiator. A solvent is disposed within the recesses. Then, the solvent is diffused into the polymeric substrate to form a substrate relief pattern that is complementary to the master pattern. and the substrate relief pattern is cured to form a flexographic printing plate.

In another embodiment, a flexographic printing plate includes a polymeric substrate having a major surface and a relief pattern projecting away from the major surface. The relief pattern has a height of at least 20 micrometers and features have a lateral dimension of 15 µm or less.

In a further example, a method of forming a flexographic printing plate includes providing a rigid microstructured master tool having a microstructure, replicating the microstructure onto a polymeric substrate with the rigid microstructured master tool to form a micro-replicated polymeric web master tool, and replicating the microstructure on a second polymeric substrate with the micro-replicated polymeric web master tool to form a micro-replicated flexographic printing plate.

### BRIEF DESCRIPTION OF THE DRAWINGS

The invention may be more completely understood in consideration of the following detailed description of various embodiments of the invention in connection with the accompanying drawings, in which:

**FIG. 1** is a schematic diagram of an illustrative flexographic printing apparatus;

**FIG. 2** is a block flow diagram of an illustrative method of forming a flexographic printing plate;

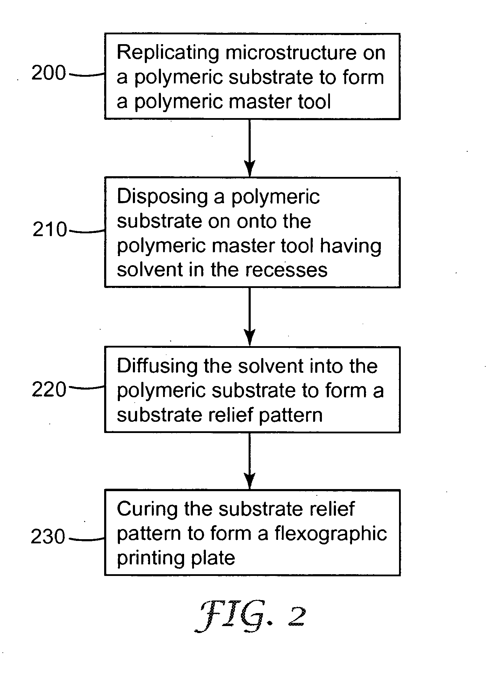

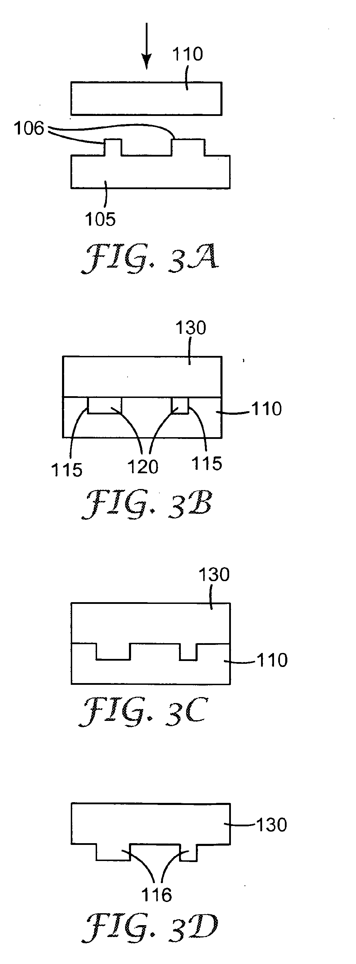

**FIG.s 3A-3D** are schematic cross-sectional diagrams of an illustrative method of forming a flexographic printing plate as described on Figure 2;

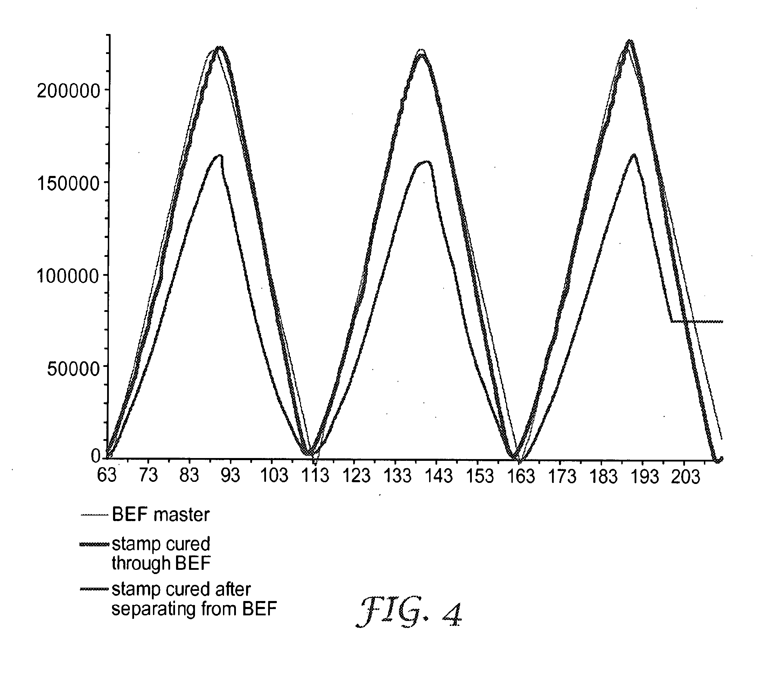

**FIG. 4** is a profilometric scan of flexographic printing plates formed in Example 1;

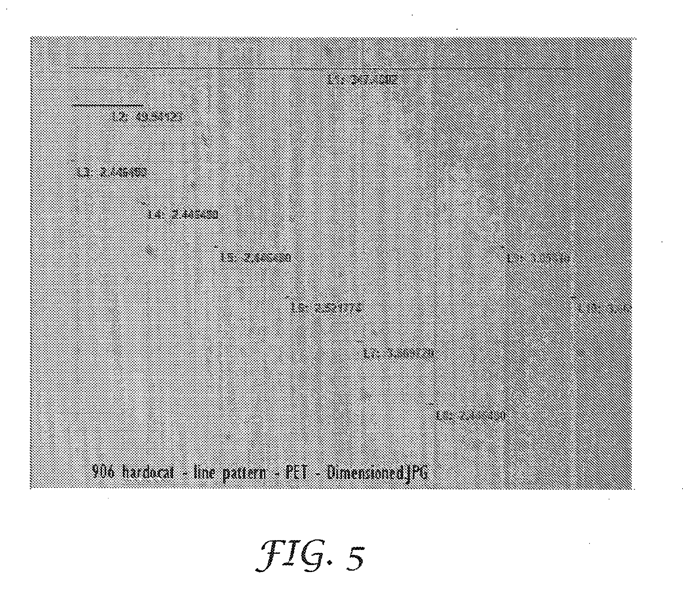

**FIG. 5** is a micrographic image of a printed surface of Example 1;

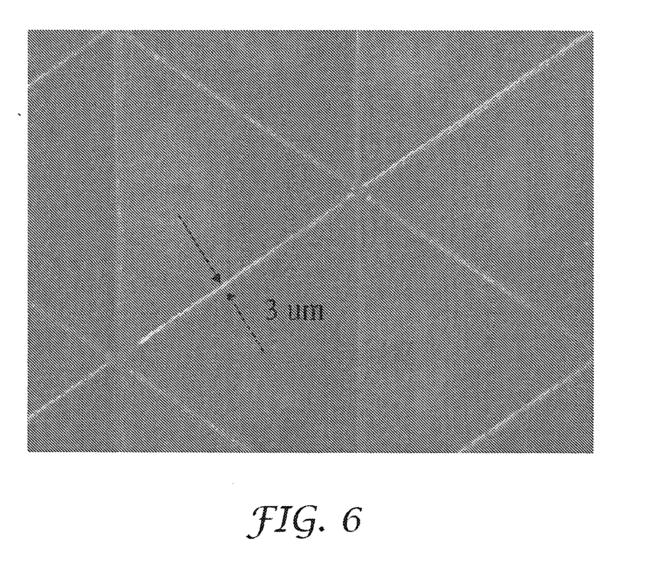

**FIG.** 6 is a micrographic image of a micro-replicated flexographic printing plate formed in Example 2; and

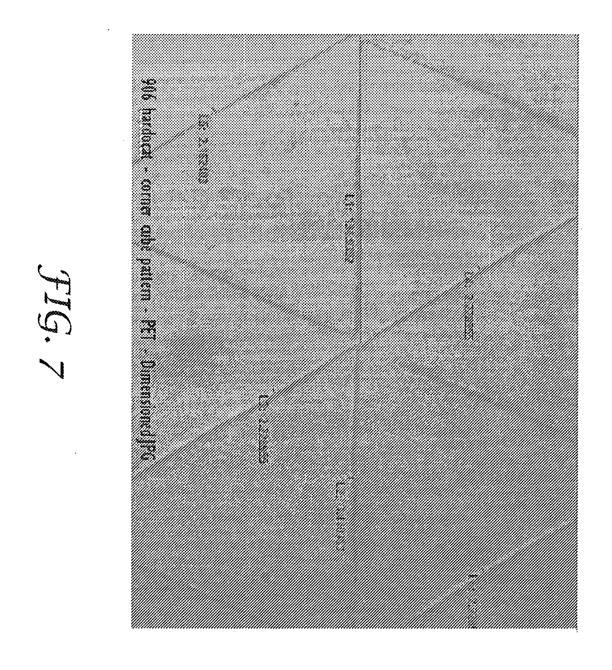

**FIG. 7** is a micrographic image of a printed surface of Example 2.

The figures are not necessarily to scale. Like numbers used in the figures refer to like components, steps and the like. However, it will be understood that the use of a number to refer to a component in a given figure is not intended to limit the component in another figure labeled with the same number.

### DETAILED DESCRIPTION

In the following description, reference is made to the accompanying drawings that form a part hereof, and in which are shown by way of illustration several specific embodiments. It is to be understood that other embodiments are contemplated and may be made without departing from the present invention. The following detailed description, therefore, is not to be taken in a limiting sense.

This disclosure relates to flexographic printing plates; and more specifically to solvent-assisted embossing of flexographic printing plates. In particular, this disclosure describes solvent-assisted embossing of a polymeric substrate that may only be partially cured. The solvent diffuses into the polymeric sheet, forming a microstructured polymeric flexographic printing plate following curing of the partially cured microstructured polymeric flexographic printing plate. Unlike conventional methods of forming flexographic printing plates, the methods disclosed herein are capable of forming flexographic printing plates having a feature size lateral dimension of less than 20 micrometers, or less than 15 micrometers, or less than 10 micrometers, and even less than 5 micrometers.

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein.

The recitation of numerical ranges by endpoints includes all numbers subsumed within that range (e.g. 1 to 5 includes 1, 1.5, 2, 2.75, 3, 3.80, 4, and 5) and any range within that range.

As used in this specification and the appended claims, the singular forms "a", "an", and "the" encompass embodiments having plural referents, unless the content clearly dictates otherwise. As used in this specification and the appended claims, the term "or" is generally employed in its sense including "and/or" unless the content clearly dictates otherwise.

All scientific and technical terms used herein have meanings commonly used in the art unless otherwise specified. The definitions provided herein are to facilitate understanding of certain terms used frequently herein and are not meant to limit the scope of the present disclosure.

As used herein, "flexographic printing" means a rotary printing process using a flexible printing plate; i.e., a flexographic printing plate. Any material that may be transferred from a flexographic printing plate to a recipient substrate may be "printed".

As used herein, "flexographic printing plate" refers to a printing plate having features onto which material to be transferred to a recipient substrate may be disposed, wherein the plate or the features are capable of deforming when contacting the recipient substrate (relative to when not contacting the recipient substrate). A flexographic printing plate can be a flat plate that can be attached to a roll or cylinder or the flexographic printing plate can be attached a sleeve attached to a chuck.

As used herein, "feature" means a raised projection of a flexographic printing plate. The raised projection has a distal surface (or land), removed from the bulk of the flexographic printing plate, onto which material may be disposed.

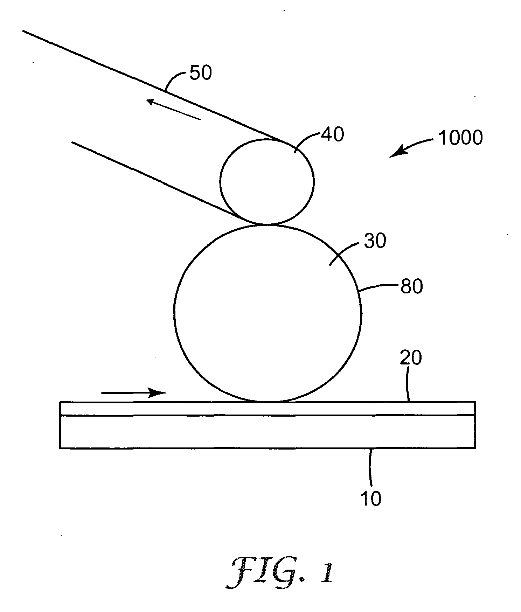

The flexographic printing rolls described herein can be used in any flexographic printing apparatus or system. FIG. 1 is a schematic diagram of an illustrative flexographic printing apparatus **1000**. The system **1000** comprises a donor substrate **10** configured to receive material **20** to be printed onto a recipient substrate **50**. The system **1000** includes a flexographic roll **30** configured to attachably receive a flexographic printing plate **80** (described below). Flexographic printing plate **80** may be attached to flexographic roll **30** using any suitable technique. One suitable technique includes attaching flexographic plate **80** to flexographic roll **30** using an adhesive.

Flexographic roll **30** is moveable relative to the donor substrate **10** such that material **20** may be transferred from donor substrate **10** to a feature (described below) of a flexographic printing plate **80**. The system **1000** depicted in **FIG. 1** further includes a substrate roll **40** positioned relative to flexographic roll **30** such that movement of substrate roll **40** relative to flexographic roll **30** is capable of causing recipient substrate **50** to move between flexographic roll **30** and substrate roll **40**, allowing material **20** to be transferred from a feature of flexographic printing plate **80**.

Flexographic roll **30** and substrate roll **40** depicted in FIG. 1 may be in the form of cylinders and the rolls **30, 40** may rotate about the respective central axes of the cylinders. Such rotation allows printing plate **80** attached to flexographic roll **30** to contact material **20** and then transfer material **20** to recipient substrate **50**. Such rotation also allows recipient substrate **50** to move between flexographic roll **30** and substrate roll **40**.

**FIG. 2** is a block flow diagram of an illustrative method of forming a flexographic printing plate and **FIG.s 3A-3D** are schematic cross-sectional diagrams of an illustrative method of forming a flexographic printing plate as described in **FIG. 2****.** In some embodiments, a polymeric master tool **110** is formed (block **200**) by replicating microstructure **106** from a rigid master tool **105**, such as, a metallic master tool **105**. Replication of the microstructure **106** from a rigid master tool **105** to form the polymeric master tool **110** can be performed by any useful method such as, for example, embossing, casting, molding, scribing, and the like. In some embodiments, the master tool is a metallic or rigid substrate that is not polymeric. In other embodiments, the rigid master tool is a rigid polymeric substrate. In some of these embodiments, the rigid master tool has microstructure that is formed by diamond turning techniques (described below) and a flexographic printing plate is replicated by any replication method (e.g., embossing, casting, ect.) with the rigid (metallic or polymeric) master tool.

The rigid master tool **105** having a relief pattern or microstructure **106** described herein can be formed via any useful method. In many embodiments, the rigid master tool features **106** are formed via diamond turning techniques. Diamond turning techniques are described in, for example, U.S. 2006/0234605.

The master tool **110**, which may be a polymeric master tool, includes a plurality of recesses **115** that correspond and define a master tool recess pattern. A solvent **120** capable of diffusing into a polymeric material is disposed within the pattern of recesses **115** and a polymeric substrate **130** is disposed (block **210**) onto the master tool **110** having the solvent **120** in the pattern of recesses **115**.

The solvent **120** diffuses (block **220**) into the polymeric substrate **130** and swells and/or dissolves a portion of the polymeric substrate **130** adjacent to the solvent **120**, causing that portion of the polymeric substrate **130** to conform to the master tool **110** pattern of recesses **115**. Once the solvent **120** dissipates, the polymer solidifies to form a relief pattern **116** having a pattern complimentary to the master tool **110** pattern of recesses 115. The relief pattern **116** can be cured (block **230**) via radiation (e.g., UV, visible, IR, or e-beam) or heat before and/or after the polymeric substrate **130** is removed from the master tool **110** and utilized as a flexographic printing plate.

The polymeric substrate forming the flexographic printing plate can be formed of any polymeric material that can be swelled and/or dissolved with a solvent and subsequently cured, forming a relief pattern. In many embodiments, the polymeric substrate includes at least one elastomeric binder, at least one curable or photopolymerizable, ethylenically unsaturated monomer, and at least one photoinitiator or initiator system, wherein the photoinitiator is sensitive to actinic radiation. Throughout this specification, actinic radiation (or actinic light) will include ultraviolet radiation and/or visible light.

Examples of elastomeric binders are polyalkadienes, alkadiene/acrylonitrile copolymers; ethylene/propylene/alkadiene copolymers; ethylene/(meth)acrylic acid(meth)acrylate copolymers; and thermoplastic, elastomeric block copolymers of styrene, butadiene, and/or isoprene. In many embodiments, the elastomeric binder includes linear and radial thermoplastic, elastomeric block copolymers of styrene and butadiene and/or isoprene.

For thermally curable polymeric substrates, a thermoplastic binder is used, such as a thermoplastic, elastomeric binder. The thermoplastic binder can be a single polymer or mixture of polymers. Binders include natural or synthetic polymers of conjugated diolefin hydrocarbons, including polyisoprene, 1,2-polybutadiene, 1,4-polybutadiene, and butadiene/acrylonitrile. In many embodiments, the thermoplastic binder is an elastomeric block copolymer of an A-B-A type block copolymer, where A represents a non-elastomeric block, preferably a vinyl polymer and most preferably polystyrene, and B represents an elastomeric block, preferably polybutadiene or polyisoprene. Suitable thermoplastic elastomeric binders of this type include poly(styrene/isoprene/styrene) block copolymers and poly(styrene/butadiene/styrene) block copolymers which are preferred. The non-elastomer to elastomer ratio is preferably in the range of from 10:90 to 35:65. In some embodiments, the thermoplastic elastomeric binder is a mixture of at least two poly(styrene/isoprene/styrene) block copolymers as described in U.S. Pat. No. 5,972,565. The binder can be present in an amount of at least 60% by weight of the photosensitive layer. The term binder, as used herein, encompasses core-shell microgels and blends of microgels and preformed macromolecular polymers, such as those disclosed in U.S. Pat. No. 4,956,252 and U.S. Pat. No. 5,707,773.

Other suitable photosensitive or curable elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete description of some of these materials see U.S. Pat. No. 5,015,556.

In many embodiments, the photo-polymerizable material contains at least one ethylenically unsaturated compound photo-polymerizable by actinic radiation. Such compounds are also referred to as monomers or oligomers. Monomers that can be used in the polymeric layer are well known in the art and include, but are not limited to, ethylenically unsaturated, copolymerizable, organic compounds, preferably having at least one terminal ethylenically unsaturated group. Generally the monomers or oligomers have relatively low molecular weights (less than about 30,000). Preferably, the monomers or oligomers have a relatively low molecular weight (less than about 5000), such as, for example, acrylates and methacrylates of monovalent or polyvalent alcohols; (meth)acrylamides; vinyl ethers and vinyl esters; etc., in particular acrylic and/or methacrylic esters of butanediol, hexanediol, diethylene glycol, trimethylol propane, pentaerythritol, etc.; and mixtures of such compounds.

If a polyacrylol oligomer is used, the oligomer should preferably have a molecular weight greater than 1000. A mixture of monofunctional and multifunctional acrylates or methacrylates may be used. Other examples of suitable monomers or oligomers include acrylate and methacrylate derivatives of isocyanates, esters, epoxides and the like. Monomers or oligomers can be appropriately selected by one skilled in the art to provide elastomeric property to the photopolymerizable composition. Examples of elastomeric monomers or oligomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than 20% by weight). Further examples of monomers or oligomers can be found in Chen U.S. Pat. No. 4,323,636; Fryd et al., U.S. Pat. No. 4,753,865; Fryd et al., U.S. Pat. No. 4,726,877 and Feinberg et al., U.S. Pat. No. 4,894,315. The monomer and/or oligomer or monomer and/or oligomer mixture can be present in an amount of at least 5%, preferably 10 to 20%, by weight by weight of the photopolymerizable material.

Suitable photoinitiators are individual photoinitiators or photoinitiator systems, such as, for example, quinones, benzophenones, benzoin ethers, aryl ketones, peroxides, biimidazoles, benzyl dimethyl ketal, hydroxyl alkyl phenyl acetophone, dialkoxy actophenone, trimethylbenzoyl phosphine oxide derivatives, aminoketones, benzoyl cyclohexanol, methyl thio phenyl morpholino ketones, morpholino phenyl amino ketones, alpha halogeno acetophenone, oxysulfonyl ketones, sulfonyl ketones, oxysulfonyl ketones, sulfonyl ketones, benzoyl oxime esters, thioxanthones, camphorquinones, ketocoumarin, Michler's ketone, etc., also mixed with triphenyl phosphine, tertiary amines, etc. In many embodiments, the initiator is sensitive to ultraviolet or visible radiation. Photoinitiators can be generally present in an amount of 0.001-10.0% by weight of the photopolymerizable material.

The thickness of the polymeric substrate can vary over a wide range depending upon the type of flexographic printing plate desired. In many embodiments, the polymeric substrate can be from about 0.05-0.17 cm in thickness, or from 0.25-0.64 cm in thickness or greater, or from 1 to 10 millimeters. Useful flexographuic printing plate polymeric substrates are described in U.S. 2005/0196701.
Useful polymeric substrates includes CYREL® brand flexographic printing plate substrates commercially available from DuPont Co. As described above, a flexographic printing plate may be a flat plate that can be attached to a roll; *e.g*., by mounting tape, or a sleeve attached to a chuck, such as with Dupont™ CYREL® round plates.

Useful solvents include any solvent that can diffuse, swell and/or dissolve the polymeric substrate. The solvent can be organic solvents, aqueous or semi-aqueous solutions, or water. The choice of the solvent will depend primarily on the chemical nature of the polymeric substrate to be swelled and/or dissolved. Suitable organic solvents include aromatic or aliphatic hydrocarbon, and aliphatic or aromatic halohydrocarbon solvents, for example, n-hexane, petrol ether, hydrated petrol oils, limonene or other terpenes or toluene, isopropyl benzene, etc., ketones such as methyl ethyl ketone, halogenated hydrocarbons such as chloroform, trichloroethane, or tetrachloroethylene, esters such as acetic acid or acetoacetic acid esters, or mixtures of such solvents with suitable alcohols. Suitable semi-aqueous solvents usually contain water and a water-miscible organic solvent and an alkaline material.

The methods described herein allow for flexographic printing plates having feature sizes that are smaller than previously known. In particular, these flexographic printing plates have a relief pattern of features that project away from the plate surface a distance (i.e., a height) of at least 20 micrometers, or at least 25 micrometers, or at least 50 micrometers, or at least 100 micrometers, have a lateral dimension of 15 micrometers or less, or 10 micrometers or less, or 5 micrometers or less, and can be spaced apart in a lateral dimension of at least 100 micrometers, or at least 150 micrometers, or at least 250 micrometers, or at least 500 micrometers, without the sagging problems associated with prior forming methods and flexographic printing plates.

EXAMPLES

Example 1

A micro-flexographic printing plate was prepared by taking a polymeric film with a micro-replicated linear prismatic structure (BEF 90/50, commercially available from 3M Co.) a profilometric scan of this master structure is illustrated in **FIG. 4** and referred to as BEF MASTER, depositing a thin layer of methyl ethyl ketone on its structured surface, and then positioning CYREL® flexographic plate (type TDR B 6.35 mm thick, with removed cover sheet, commercially available from DuPont Co.) on the top of the micro-replicated surface. After 15 hours, the CYREL® plate was exposed to UV radiation through the attached micro-replicated film in a UV processor (Fusion UV Curing lamp, model MC-6RQN, Rockville, MD, 200 watt/in, mercury lamp, run at approximately 5 fpm) and then the micro-replicated flexographic printing plate was detached from the BEF master. A profilometric scan of this micro-replicated flexographic printing plate illustrating the features is shown in **FIG. 4** and referred to as STAMP CURED THROUGH BEF. The x-axis scale is in micrometers and the y-axis scale is in angstroms.

**FIG. 4** also illustrates a profilometric scan of another micro-replicated flexographic printing plate formed according to the above method except that the micro-replicated flexographic printing plate was cured after it was detached from the BEF master. A profilometric scan of this micro-replicated flexographic printing plate is shown in **FIG. 4** and referred to as STAMP CURED AFTER SEPARATING FROM BEF.

The micro-replicated flexographic printing plate of STAMP CURED THROUGH BEF was attached to a 12.7 cm-diameter glass cylinder by flexographic mounting tape (type 1120, commercially available from 3M Co.). A thin layer of 906 hardcoat (3M's 906 hardcoat is a 33 wt% solids ceramer hardcoat dispersion containing 32 wt% 20nm SiO₂ nano-particles, 8 wt% N,N-dimethyl acrylamid, 8 wt% methacryloxypropyl trimethoxysilane and 52 wt% pentaerythritol tri/tetra acrylate (PETA) in IPA ) was deposited onto a clean in glass slide (available from Erie Scientific Company, Portsmouth, NH) by dip coating at 0.03 meters per minute from the 906 hardcoat solution in IPA (25 wt% solids), and drying that glass slide in open air. The flexographic printing plate was then rolled by hand in that layer of hardocat and then rolled onto a clean 125 micrometer PET i.e., poly(ethylene terephtalate) film (available from DuPont Co). This PET film with printed lines was sent through a UV processor (Fusion UV Curing lamp, model MC-6RQN, Rockville, MD, 200 watt/inch, mercury lamp, purged by nitrogen to approximately 50 ppm of oxygen, run at approximately 1.5 meters per minute). The resulting printed 906 hardcoat lines were approximately 2.5 micrometers wide and spaced apart by approximately 50 micrometers forming a parallel line pattern illustrated with the micrographic image of **FIG. 5**.

Example 2

A micro-flexographic printing plate was prepared by taking a polymeric film with a microreplicated comer-cube structure, depositing a small amount of methyl ethyl ketone on the master tool structured surface, and then positioning a CYREL® flexographic plate (type TDR B 6.35 mm thick, with removed cover sheet, available from DuPont Co.) on the top of the master tool micro-replicated surface. After 15 hours, the CYREL® plate was exposed to UV radiation through attached micro-replicated film in a UV processor (Fusion UV Curing lamp, model MC-6RQN, Rockville, MD, 200 watt/in, mercury lamp, run at approximately 1.5 meters per second) and then the micro-replicated flexographic printing plate was detached from the master tool. This micro-replicated flexographic printing plate was then attached to a 12.7 cm-diameter glass cylinder by flexographic mounting tape (type 1120, commercially available from 3M Co.). A micrographic image of this micro-replicated flexographic printing plate illustrating the features is shown in **FIG. 6**.

A thin layer of 906 hardcoat (described in Example 1) was deposited onto a clean glass slide by dip coating at 0.03 meters per minute from a 906 hardcoat solution in IPA (25 wt% solids), and drying that glass slide in open air. The flexographic printing plate was then rolled by hand in that layer of hardocat and then rolled onto a clean 125 micrometer PET i.e., poly(ethylene terephtalate) film (available from DuPont Co). This PET film with printed lines was sent through a UV processor (Fusion UV Curing lamp, model MC-6RQN, Rockville, MD, 200 watt/inch, mercury lamp, purged by nitrogen to approximately 50 ppm of oxygen, run at approximately 1.5 meters per minute). The resulting printed lines were approximately 3 micrometers wide and 135 micrometers long forming a triangular pattern as illustrated in the micrographic image shown in **FIG. 7**.

Thus, embodiments of the SOLVENT-ASSISTED EMBOSSING OF FLEXOGRAPHIC PRINTING PLATES are disclosed. One skilled in the art will appreciate that embodiments other than those disclosed are envisioned. The disclosed embodiments are presented for purposes of illustration and not limitation, and the present invention is limited only by the claims that follow.

## Claims

1. A method of forming a flexographic printing plate (80), comprising:
disposing a polymeric substrate (130) comprising at least one elastomeric binder, at least one photopolymerizable, ethylenically unsaturated monomer or oligomer, and at least one photoinitiator onto a master tool (110) having a plurality of recesses (115) defining a master tool pattern, with a solvent disposed within the recesses (115);
diffusing the solvent into the polymeric substrate (130) to form a substrate relief pattern that is complementary to the master pattern; and
curing the substrate relief pattern by exposing the polymeric substrate (130) to actinic radiation to form a flexographic printing plate (80).

2. The method according to claim 1, wherein the substrate relief pattern comprises features having a lateral dimension of 15 µm or less.

3. The method according to claim 1, further comprising removing the polymeric substrate (130) from the master tool (110) after the diffusing step.

4. The method according to claim 1, wherein the polymeric substrate is partially cured before the disposing step.

5. The method according to claim 1, wherein the curing step occurs while the substrate relief pattern is disposed within the master pattern.

6. The method according to claim 1, wherein the master tool (110) is a polymeric master tool.

7. The method according to claim 1 wherein the substrate relief pattern comprises features having a lateral dimension of 10 µm or less.

8. A flexographic printing plate formed by a method according to any of claims 1 to 7, the printing plate comprising;
a polymeric substrate (130) obtainable by curing a polymeric material by actinic radiation, the polymeric material comprising at least one elastomeric binder, at least one photopolymerizable , ethylenically unsaturated monomer or oligomer, and at least one photoinitiator,
said polymeric substrate (130) having a major surface and a relief pattern projecting away from the major surface, the relief pattern having a height of at least 20 micrometers and the relief pattern comprises features having a lateral dimension of 15 µm or less.

9. The flexographic printing plate according to claim 8, wherein the relief pattern has a height of at least 25 micrometers.

10. The flexographic printing plate according to claim 8, wherein relief pattern comprises features spaced apart in a lateral dimension of at least 100 µm.

## Patentansprüche

1. Verfahren zum Bilden einer Flexodruckplatte (80), das Folgendes umfasst:
Anordnen eines polymeren Substrats (130), das mindestens ein elastomeres Bindemittel, mindestens ein photopolymerisierbares, ethylenisch ungesättigtes Monomer oder Oligomer und mindestens einen Photoinitiator umfasst, auf einem Originalwerkzeug (110) mit mehreren Aussparungen (115), die ein Originalwerkzeugmuster definieren, wobei in den Aussparungen (115) ein Lösungsmittel angeordnet wird;
Eindiffundieren des Lösungsmittels in das polymere Substrat (130) zum Bilden eines Substratreliefmusters, das zu dem Originalmuster komplementär ist; und
Härten des Substratreliefmusters durch Bestrahlen des polymeren Substrats (130) mit aktinischer Strahlung zum Bilden einer Flexodruckplatte (80).

2. Verfahren nach Anspruch 1, bei dem das Substratreliefmuster Strukturelemente mit einer Lateralabmessung von 15 µm oder weniger aufweist.

3. Verfahren nach Anspruch 1, das ferner das Entfernen des polymeren Substrats (130) von dem Originalwerkzeug (110) nach dem Eindiffusionsschritt umfasst.

4. Verfahren nach Anspruch 1, bei dem das polymere Substrat vor dem Anordnungsschritt teilweise gehärtet wird.

5. Verfahren nach Anspruch 1, bei dem der Härtungsschritt während des Anordnens des Substratreliefmusters in dem Originalmuster stattfindet.

6. Verfahren nach Anspruch 1, bei dem es sich bei dem Originalwerkzeug (110) um ein polymeres Originalwerkzeug handelt.

7. Verfahren nach Anspruch 1, bei dem das Substratreliefmuster Strukturelemente mit einer Lateralabmessung von 10 µm oder weniger aufweist.

8. Flexodruckplatte, gebildet durch ein Verfahren nach einem der Ansprüche 1 bis 7, wobei die Druckplatte Folgendes umfasst:
ein polymeres Substrat (130), das durch Härten eines polymeren Materials durch aktinische Strahlung erhältlich ist, wobei das polymere Material mindestens ein elastomeres Bindemittel, mindestens ein photopolymerisierbares, ethylenisch ungesättigtes Monomer oder Oligomer und mindestens einen Photoinitiator umfasst,
wobei das polymere Substrat (130) eine Hauptoberfläche und ein von der Hauptoberfläche weg vorstehendes Reliefmuster aufweist, wobei das Reliefmuster eine Höhe von mindestens 20 Mikrometern aufweist und das Reliefmuster Strukturelemente mit einer Lateralabmessung von 15 µm oder weniger aufweist.

9. Flexodruckplatte nach Anspruch 8, wobei das Reliefmuster eine Höhe von mindestens 25 Mikrometern aufweist.

10. Flexodruckplatte nach Anspruch 8, wobei das Reliefmuster Strukturelemente umfasst, die in einer Lateralabmessung von mindestens 100 µm beabstandet sind.

## Revendications

1. Procédé de formation d'une plaque d'impression flexographique (80), comprenant les étapes suivantes:
disposer un substrat polymère (130) comprenant au moins un liant élastomère, au moins un monomère ou un oligomère photo-polymérisable éthyléniquement insaturé, et au moins un photo-initiateur, sur un maître-outil (110) comportant une pluralité d'évidements (115) qui définissent un motif de maître-outil, avec un solvant disposé à l'intérieur des évidements (115);
diffuser le solvant dans le substrat polymère (130) afin de former un motif en relief du substrat qui est complémentaire au motif maître, et
faire durcir le motif en relief du substrat en exposant le substrat polymère (130) à un rayonnement actinique afin de former une plaque d'impression flexographique (80).

2. Procédé selon la revendication 1, dans lequel le motif en relief du substrat comprend des caractéristiques qui présentent une dimension latérale de 15 µm, ou moins.

3. Procédé selon la revendication 1, comprenant en outre l'enlèvement du substrat polymère (130) du maître-outil (110) après l'étape de diffusion.

4. Procédé selon la revendication 1, dans lequel le substrat polymère est partiellement durci avant l'étape de disposition.

5. Procédé selon la revendication 1, dans lequel l'étape de durcissement est exécutée alors que le motif en relief du substrat est disposé à l'intérieur du motif maître.

6. Procédé selon la revendication 1, dans lequel le maître-outil (110) est maître-outil polymère.

7. Procédé selon la revendication 1, dans lesquels le motif en relief du substrat comprend des caractéristiques qui présentent une dimension latérale de 10 µm, ou moins.

8. Plaque d'impression flexographique formée par un procédé selon l'une quelconque des revendications 1 à 7, la plaque d'impression comprenant:
un substrat polymère (130) qui peut être obtenu en faisant durcir un matériau polymère avec un rayonnement actinique, le matériau polymère comprenant au moins un liant élastomère, au moins un monomère ou un oligomère photo-polymérisable éthyléniquement insaturé, et au moins un photo-initiateur,
ledit substrat polymère (130) présentant une surface majeure et un motif en relief en saillie à partir de la surface majeure, le motif en relief présentant une hauteur d'au moins 20 micromètres, et le motif en relief comprenant des caractéristiques qui présentent une dimension latérale de 15 µm, ou moins.

9. Plaque d'impression flexographique selon la revendication 8, dans laquelle le motif en relief présente une hauteur d'au moins 25 micromètres.

10. Plaque d'impression flexographique selon la revendication 8, dans laquelle le motif en relief comprend des caractéristiques qui sont espacées dans une dimension latérale d'au moins 100 µm.
